# EUROPEAN PATENT APPLICATION

(11) **EP 4 701 084 A1**
(43) Date of publication of application: **25.02.2026**
(21) Application number: 24792393.1
(22) Date of filing: 13.03.2024
(51) Int. Cl.: H03M 1/10, H02J 7/00

(54) **A/D CONVERTER FAULT DETECTION DEVICE, POWER SUPPLY DEVICE COMPRISING SAME, AND A/D CONVERTER FAULT DETECTION METHOD**

(30) Priority: 18.04.2023 JP 2023067921
(71) Applicant: Panasonic Intellectual Property Management Co., Ltd., Kadoma-shi, Osaka 571-0057 (JP)
(72) Inventor: OKUMURA, Masashi, Kadoma-shi, Osaka 571-0057 (JP); OHASHI, Osamu, Kadoma-shi, Osaka 571-0057 (JP)
(74) Representative: Eisenführ Speiser
(86) International application number: PCT/JP2024/009879
(87) International publication number: WO 2024/219117

(57) **Abstract**

An A/D converter-failure detection device includes a second IC including a second A/D converter configured to converts a second analog value of a reference signal detected at a second reference terminal into a second digital signal at a second resolution, with the second analog value being acquired, and a second communication terminal connected to a first communication terminal and configured to communicate with the first communication terminal. A first IC configured to transmit a first digital signal from the first communication terminal to the second communication terminal. A first A/D converter configured to A/D-convert a first analog value of the reference signal detected by a first reference terminal into the first digital signal. The second IC is configured to compare the second digital signal with the first digital signal received at the second communication terminal to obtain a difference between the signals. The second digital signal is obtained by A/D-converting the second analog value of the reference signal detected by the second reference terminal at the second resolution by the second A/D converter. The second IC is configured to determine an occurrence of a failure when the difference exceeds a predetermined reference value.

## Description

### TECHNICAL FIELD

The present disclosure relates to an A/D converter-failure detection device, a power supply device including the A/D converter-failure detection device, and a method of detecting failures of A/D converters.

### BACKGROUND ART

Electrical apparatuses including A/D converters have been used in various fields. For example, the following are used in a variety of fields including mobile applications: power supply devices for powering electrical apparatuses by using rechargeable secondary batteries such as lithium-ion secondary batteries, and electrical apparatuses equipped with the power supply devices (e.g., PTL 1).

### CITATION LIST

### Patent Literature

PTL 1: Japanese Patent Laid-Open Publication No. 2015-109741

### SUMMARY OF INVENTION

In an electrical apparatus equipped with such an A/D converter described above, analog values, such as detected values of electrical currents, and temperatures, are processed into digital signals with an A/D converter on the analog front end (AFE) side thereof, and then transmitted to an IC.

The A/D converter of such an electrical apparatus is failed, the electrical apparatus no longer operates properly. For example, in a charger whose safety is ensured by measuring an overcurrent or overtemperature and cutting off its power when the current or temperature exceeds a predetermined threshold value, abnormal conditions may not be detected.

Therefore, functional safety has been demanded which can ensure safety even if a failure occurs in any of the components. The functional safety typically involves a redundant mechanism provided physically with two ICs that can ensure the operation even if a failure occurs in any of the two.

However, implementation of such a redundant mechanism has required plural ICs, which poses a problem of increased hardware, leading to a large-sized circuit, an increased power consumption, and a complicated circuit configuration.

An A/D converter-failure detection device according to one aspect of the present disclosure includes a first IC and a second IC. The first IC includes: a first reference terminal configured to acquire a first analog value of a predetermined reference signal; a first A/D converter configured to convert the first analog value acquired at the first reference terminal into a first digital signal at a first resolution; and a first communication terminal configured to communicate with a part other than the first IC. The second IC includes: a second reference terminal configured to acquire a second analog value of the predetermined reference signal; a second A/D converter configured to convert the second analog value acquired at the second reference terminal into a second digital signal at a second resolution; and a second communication terminal connected to the first communication terminal, the second communication terminal and configured to communicate with the first communication terminal. The first IC is configured to transmit the first digital signal from the first communication terminal to the second communication terminal, the first digital signal being obtained by A/D-converting the first analog value of the predetermined reference signal at the first resolution by the first A/D converter, the first analog value being acquired at the first reference terminal. The second IC is configured to: compare the second digital signal with the first digital signal to obtain a difference between the second digital signal and the first digital signal, the second digital signal being obtained by A/D-converting the second analog value of the predetermined reference signal at the second resolution by the second A/D converter, the second analog value being acquired at the second reference terminal, the first digital signal being received at the second communication terminal; and determine a failure when the difference exceeds a predetermined reference value.

A failure detection method according to another aspect of the present disclosure is a method of an A/D converter-failure detection device which includes: a first IC including a first reference terminal connected to a predetermined reference signal, a first A/D converter converting a first analog value of the predetermined reference signal detected at the first reference terminal into a first digital signal at a first resolution, and a first communication terminal communicating with other part; and a second IC including a second reference terminal connected to the predetermined reference signal, a second A/D converter converting a second analog value of the predetermined reference signal detected at the second reference terminal into a second digital signal at a second resolution, and a second communication terminal connected to and communicating with the first communication terminal. The failure detection method includes: allowing the first IC to detect the first analog value of the predetermined reference signal at the first reference terminal, to convert the first analog value into the first digital signal at the first resolution by the first A/D converter, and to transmit the first digital signal from the first communication terminal to the second communication terminal; allowing the second IC to detect the second analog value of the predetermined reference signal at the second reference terminal, and to convert the second analog value into the second digital signal at the second resolution by the second A/D converter; allowing the second IC to receive, at the second communication terminal, the first digital signal transmitted from the first IC; and allowing the second IC to compare the first digital signal with the second digital signal to obtain a difference between the first digital signal and the second digital signal, and to determine an occurrence of a failure when the difference exceeds a predetermined reference value.

Failure detection of A/D converters is performed with software in accordance with one aspect of the present disclosure that involves the A/D converter-failure detection device including the A/D converter-failure detection device, and the A/D converter-failure detection method.

### BRIEF DESCRIPTION OF DRAWINGS

FIG. 1 is a block diagram of an A/D converter-failure detection device according to Exemplary Embodiment 1.
FIG. 2 is a block diagram of a power supply device including an A/D converter-failure detection function.

### DESCRIPTION OF EMBODIMENTS

Exemplary embodiments of the present disclosure may be specified by the following configurations and features.

In an A/D converter-failure detection device according to another aspect of the present disclosure in any of the aspects described above, the first resolution is different from the second resolution, and the second IC is configured to normalize the first digital signal and the second digital signal in accordance with the first resolution and the second resolution so as to compare the second digital signal with the first digital signal. This configuration makes possible failure determination by software after the resolutions have been made comparable by normalization, while ICs including A/D converters with different resolutions are used in a mixed manner.

In an A/D converter-failure detection device according to still another aspect of the present disclosure in any of the aspects described above, the second IC is configured to normalize one of the first digital signal and the second digital signal which is A/D-converted at a higher one of the first resolution and the second resolution to match another of the first digital signal and the second digital signal which is A/D-converted at a lower one of the first resolution and the second resolution.

In an A/D converter-failure detection device according to still another aspect of the present disclosure in any of the aspects described above, the first resolution is higher than the second resolution.

An A/D converter-failure detection device according to still another aspect of the present disclosure in any of the aspects described above further includes a reference-signal generator configured to generate the predetermined reference signal.

In an A/D converter-failure detection device according to still another aspect of the present disclosure in any of the aspects described above, the predetermined reference signal is a predetermined reference voltage.

In an A/D converter-failure detection device according to still another aspect of the present disclosure, in any of the aspects described above, the reference-signal generator includes a voltage converter circuit configured to convert a power voltage configured to power the first IC or the second IC into the predetermined reference voltage lower than the power voltage.

In an A/D converter-failure detection device according to still another aspect of the present disclosure in any of the aspects described above, the first IC further includes an analog input terminal configured to receive an external analog signal. The first IC is configured to: convert the external analog signal received at the analog input terminal into a digital value by the first A/D converter; and transmit the digital value from the first communication terminal to the second communication terminal.

A power supply device according to another aspect of the present disclosure includes an A/D converter-failure detection device according to any one of the aspects described above, one or more secondary battery cells, and a charging-discharging circuit configured to charge and discharge the one or more secondary battery cells. The first IC is an analog front end (AFE) configured to measure a temperature of the one or more secondary battery cells or an electrical current of the one or more secondary battery cells. The second IC is a micro controller (MCU) configured to control the power supply device.

Exemplarily embodiments of the present disclosure will be described below with reference to the accompanying drawings. However, the exemplary embodiments described below are examples for embodying the technical idea of the present disclosure, and the present disclosure is not limited to the following description. Moreover, this specification never limits the members described in the claims to the members of the exemplary embodiments. Unless otherwise specified, the dimensions, materials, shapes, relative positions, and the like of the configuration components described in the exemplary embodiments are not intended to limit the scope of the present disclosure but are merely illustrative examples. It should be noted that the sizes, positional relationships, and the like of members illustrated in the drawings may be exaggerated for clarity of explanation. Furthermore, in the following description, the same names and reference numerals indicate the same or similar members, and detailed description will be appropriately omitted. Furthermore, regarding elements that configure the present disclosure, a plurality of elements may be composed of the same member so that one member serves as a plurality of elements, or conversely, the function of one member can be shared and achieved by a plurality of members.

The A/D converter-failure detection device according to the present disclosure is preferably applied to electrical apparatuses, such as a charger equipped with batteries. Such electrical apparatuses include electric power sources for powering machinery, such as power-assisted bicycles, electric scooters for use in home-delivery service, electric carts for use in sites e.g., golf courses, factories, and airports, and autonomously travelling robots for home-delivery service. Further included are electric power sources for powering machinery that includes construction machines, vehicles e.g., hybrid vehicles and electric vehicles, and portable electrical apparatuses e.g., radio devices, electric cleaners, and electric tools. Yet further included, in stationary power-storage application, are backup power supplies for servers, and power supply devices for households, business places, and factories. Hereinafter, as an exemplary embodiment of the present disclosure, a battery pack for power-assisted bicycles will be described.

### Exemplary Embodiment 1

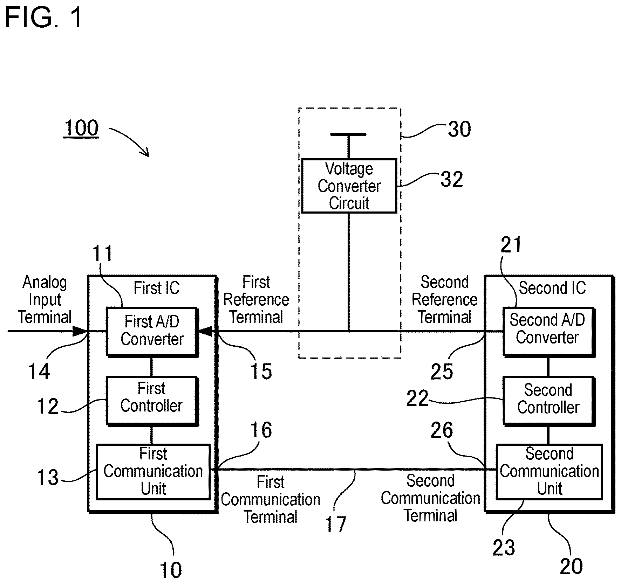

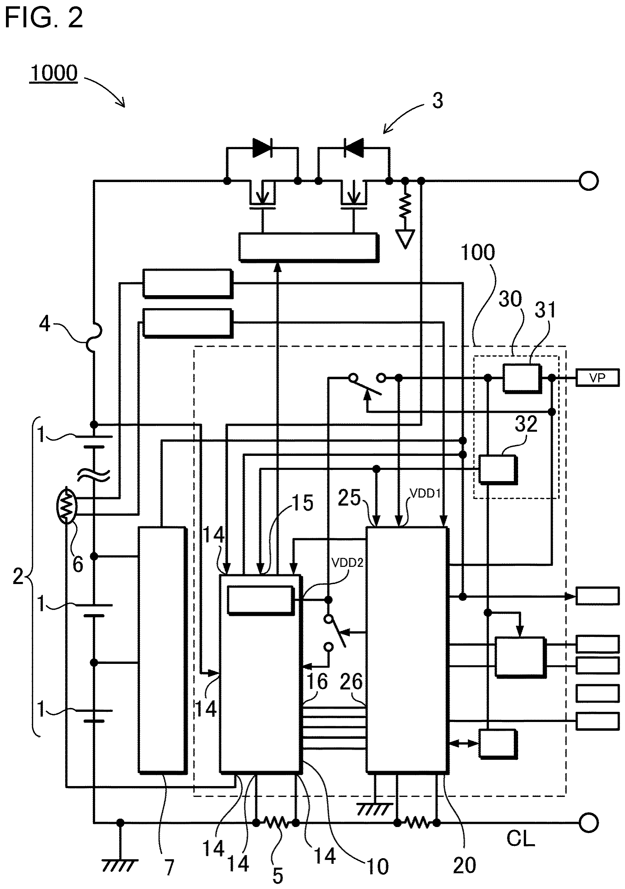

FIGS. 1 and 2 show A/D converter-failure detection device 100 according to Exemplary Embodiment 1 of the present disclosure2. FIG. 1 is a block diagram of A/D converter-failure detection device 100 according to Embodiment 1. FIG. 2 is a block diagram of power supply device 1000 having an A/D converter-failure detection function. A/D converter-failure detection device 100 shown in these figures is used by being incorporated in an electrical apparatus, such as a charger and a power supply device. For example, power supply device 1000 shown in FIG. 2 is illustrated as a battery pack including charging-discharging circuit 3. The battery pack is used by being set in an electrical apparatus to be powered. Power supply device 1000 may be detachably attached to the electrical apparatus, or may be integrated into the electrical apparatus. Power supply device 1000 is configured to measure various quantities, such as battery voltages, voltages of parts, and temperatures of batteries, and electrical components, such as a switching element. Power supply device 1000 performs these measurements through an analog front end (AFE) to detect analog signals, and then converts the detected analog signals into digital signals, followed by processing the digital signals with a micro controller (MCU). For performing these A/D conversions, the power supply device includes A/D converters. Upon occurring, a malfunction such as a failure in the A/D converters prevents the device from operating correctly. Therefore, for functional safety, an A/D converter-failure detection function for detecting failures in the A/D converters is required.

For example, in some chargers, an IC that monitors over-charging is added to provide redundancy in order to protect the batteries from over-charging. In FIG. 2, second protection circuit 7 corresponds to such an additional IC. However, as for a mechanism for protecting the batteries from suffering critical conditions such as over-discharging and overheating exceeding a predetermined temperature, no redundant mechanism has been provided. Additional ICs for individually monitoring them, aiming at providing redundancy even for such conditions, will increase hardware configuration in size, resulting in more complicated system and higher cost.

In contrast, A/D converter-failure detection device 100 according to the first embodiment allows attention to be focused on the fact that each IC includes an individual A/D converter. Based on this, an identical reference signal may be A/D-converted individually by the different ICs having individual A/D conversion functions into A/D-converted reference signals. The resulting signals are then compared to each other, thereby detecting a failure of the A/D converters. This configuration allows a failure determination function of the A/D converters to be implemented by software using an existing configuration without adding any additional IC, achieving advantages of inexpensive, improved functional safety. Details will be described below with reference to FIG. 1.

A/D converter-failure detection device 100 shown in FIG. 1 includes first IC 10, second IC 20, and reference-signal generator 30.

### First IC 10

First IC 10 includes first A/D converter 11, first controller 12, and first communication unit 13. First controller 12 is connected to first A/D converter 11 and first communication unit 13, and controls their operations. First IC 10 further includes, as external connection terminals, analog input terminal 14, first reference terminal 15, and first communication terminal 16. Analog input terminal 14 is configured to receive external analog signals. In FIG. 1, although it is only one analog input terminal 14 that is illustrated for the sake of explanation, first IC 10 may include plural analog input terminals. First reference terminal 15 to be described later is one of analog input terminals 14. In the case where the IC includes the plural analog input terminals, the input signals may be switched with a multiplexer. First IC 10 may be implemented by an analog front end (AFE). The AFE is an analog circuit that connects signal detection devices, such as a sensor, to a digital-signal processing device, such as a microcomputer.

First reference terminal 15 is configured to acquire a first analog value of a predetermined reference signal. The function of first reference terminal 15 is equivalent to that of analog input terminal 14. In other words, any one of the plural analog input terminals 14 of first IC 10 may be used as first reference terminal 15. Analog input terminals 14 including first reference terminal 15 are connected to an input port of first A/D converter 11.

### First A/D Converter 11

First A/D converter 11 receives an external analog signal via analog input terminal 14, and converts the received analog signal into a digital signal at a first resolution, and then, sending the digital signal to first controller 12. Then, first controller 12 transmits the digital signal from first communication terminal 16 to second IC 20. First A/D converter 11 may convert the first analog value of the predetermined reference signal detected via first reference terminal 15 into a first digital signal at the first resolution similarly to above, and then, sends the first digital signal to first controller 12. Then, first controller 12 transmits the first digital signal from first communication terminal 16 to second IC 20.

### Reference-Signal Generator 30

Reference-signal generator 30 generates a predetermined reference signal. The predetermined reference signal may be a reference voltage. The reference voltage is generated preferably using a power voltage for powering first IC 10 and second IC 20.

First reference terminal 15 is connected to reference-signal generator 30. First IC 10 acquires the predetermined reference signal as the first analog value through first reference terminal 15. Then, the first analog value is converted into a first digital signal with first A/D converter 11.

### Voltage Converter Circuit

The reference signal is a converted voltage value which is preferably lower than the power voltage. Reference-signal generator 30 includes voltage converter circuit 32 configured to convert the power voltage, which is for powering first IC 10 or second IC 20, into a predetermined reference voltage lower than the power voltage. Assuming, for example, that the predetermined reference voltage ranges from 40% to 60% of the power voltage. This configuration allows the reference signal to be set at a middle point of the detection-range of first A/D converter 11 that detects the power voltage, thereby allowing voltage measurements with the resolution of first A/D converter 11.

First communication unit 13 is configured to communicate with second communication unit 23 of second IC 20. First communication terminal 16 of first communication unit 13 is connected to second communication terminal 26 of second communication unit 23 via communication line 17.

### Second IC 20

Second IC 20 includes second A/D converter 21, second controller 22, and second communication unit 23. Second controller 22 is connected to second A/D converter 21 and second communication unit 23, and controls their operations. Second controller 22 performs a function as a comparator to be described later. In addition, second IC 20 further includes second reference terminal 25 and second communication terminal 26 as external connection terminals. Second IC 20 may be implemented by a digital-signal processing device, such as a CPU or an MPU, an ASIC, or a microcomputer.

Second reference terminal 25 is configured to acquire a second analog value of the reference signal. Second reference terminal 25 is connected to an input port of second A/D converter 21. Second reference terminal 25 is connected to reference-signal generator 30. Second IC 20 acquires the predetermined reference signal as the second analog value through second reference terminal 25.

### Second A/D Converter 21

Second A/D converter 21 receives the second analog value at second reference terminal 25, converts the second analog value into a second digital signal at a second resolution, and sends the second digital signal to second controller 22.

Second communication unit 23 is configured to communicate with first communication unit 13 of first IC 10. Second communication terminal 26 of second communication unit 23 is connected to first communication terminal 16 of first communication unit 13 via communication line 17. Second IC 20 causes second communication unit 23 to receive, via second communication terminal 26, the first digital signal that is transmitted from first IC 10 via communication line 17. The received first digital signal is sent from second communication unit 23 to second controller 22.

A/D converter-failure detection device 100 has a failure detection function for detecting failures of first A/D converter 11 and second A/D converter 21. Second controller 22 is configured to determine the failures. Specifically, second controller 22 compares the second digital signal with the first digital signal in which both signals are obtained from the same reference signal as follows: The second digital signal is obtained by second A/D converter 21 converting the same reference signal detected via second reference terminal 25. The first digital signal is obtained by second communication unit 23 receiving the signal obtained by A/D-converting the same reference signal by first A/D converter 11. Since the first digital signal and the second digital signal are obtained by A/D converting the same reference signal, the signals are to have almost the same value within quantization errors. If any malfunction occurs in either first A/D converter 11 or second A/D converter 21, the A/D conversion will not be performed correctly, resulting in a discrepancy between the first digital signal and the second digital signal. Therefore, by detecting such a discrepancy, it is possible to detect that the A/D conversion function is in trouble. Specifically, second controller 22 calculates a difference between the first digital signal and the second digital signal. Second controller 22 thus has a function as a comparator. A comparator disposed in second IC 20 is preferably used. Then, when the difference exceeds a predetermined reference value, it determines that a failure has occurred. This configuration allows software to be used for detecting malfunctions of the A/D conversion function of either first IC 10 or second IC 20 without relying on a hardware configuration, such as duplicated A/D converters. This configuration provides an advantage of functional safety added at low cost.

### Normalization

Prior to comparing the first digital signal with the second digital signal, in the case that the first resolution of first A/D converter 11 is different from the second resolution of second A/D converter 21, the signals are normalized to march the number of bits under the first resolution and the number of bits under the second resolution.

The first digital signal and the second digital signal are normalized by converting at least one of the first digital signal and the second digital signal such that the number of bits of the first digital signal becomes equal to the number of bits of the second digital signal. Second IC 20 normalizes the first digital signal and the second digital signal in accordance with the first and second resolutions, and then compares the second digital signal with the first digital signal. This configuration allows software to be used for determining the occurrence of failure while employing ICs including A/D converters with different resolutions.

In the normalization, the signal of the higher resolution of the first resolution and the second resolution is preferably normalized to match the signal of the lower resolution of the first resolution and the second resolution. This configuration avoids the expansion in quantization error that occurs when values A/D-converted by the lower-resolution A/D converter are converted to match values A/D-converted by the higher resolution, thereby providing more accurate and steady difference detection.

In general, first A/D converter 11 of first IC 10 composed of, e.g., an AFE often has a higher resolution and a larger number of bits than second A/D converter 21 of second IC 20 composed of, e.g., a CPU. That is, since the first resolution (e.g., 12 bits) of first A/D converter 11 is higher than the second resolution (e.g., 10 bits) of second A/D converter 21, the normalization is preferably to allow the first resolution to match the second resolution.

### Reference Signal

The reference signal to be used as a reference for the comparison may be separately prepared. Besides this, an existing voltage is available as the reference signal, allowing the implementation of functional safety without additional members. In this case, the power voltage for powering first IC 10 and second IC 20 is used as the reference signal. However, the power voltage is not used as it is as the reference signal. Before being used as the reference signal, the power voltage is converted into a constant voltage, a converted voltage. As described above, reference-signal generator 30 causes voltage converter circuit 32 to convert the power voltage into the converted voltage lower than the power voltage. In power supply device 1000 shown in FIG. 2, reference-signal generator 30 includes power supply circuit 31 that converts power supply voltage VP (e.g., DC 12 V) supplied from the outside into power voltages VDD1 and VDD2 (e.g., DC 5 V) for first IC 10 and second IC 20. First IC 10 is powered with the power voltage supplied via terminal VDD1, and second IC 20 is powered with the power voltage supplied via terminal VDD2.

Reference-signal generator 30 includes voltage converter circuit 32 configured to convert power voltage VDD into converted voltage VL (e.g., DC 3.3 V) lower than power voltage VDD. An output port of voltage converter circuit 32 is connected to both first reference terminal 15 of first IC 10 and second reference terminal 25 of second IC 20. Converted voltage VL is A/D-converted by first A/D converter 11 into an A/D-converted value while converted voltage VL is A/D-converted by second A/D converter 21 into another A/D-converted value. The A/D-converted values are compared with each other by second controller 22. First A/D converter 11 and second A/D converter 21 have respective dynamic ranges such that the maximum values of the respective resulting A/D-converted values become equal to power voltage VDD (e.g., DC 5 V). Therefore, converted voltages VL (e.g., DC 3.3 V) set to the midpoints of their respective dynamic ranges avoid saturation in A/D-conversion even if fluctuations occur in the digital signals caused by a malfunction of the A/D converters, resulting in correct determination.

### Timing of Failure Determination

The timing and period for the failure detection performed by second controller 22 may be optionally determined. For example, the failure detection may be performed with a predetermined operation timing of, e.g., start-up and power-off of a charger or electrical apparatus in which A/D converter-failure detection device 100 is mounted. Alternatively, the failure detection may be periodically performed with predetermined periods, such as, every 250 msec.

### Power Supply Device 1000

Power supply device 1000 shown in FIG. 2, as an example of power supply device 1000 including A/D converter-failure detection device 100, has not only a function of discharging built-in secondary battery cells 1 and thereby supplying the electric power to a powering target, but also a function of charging secondary battery cells 1. Power supply device 1000 includes one or more secondary battery cells 1, charging-discharging circuit 3 for charging and discharging one or more secondary battery cells 1, fuse 4, current-detecting resistor 5, and A/D converter-failure detection device 100. In this case, plural rechargeable secondary battery cells are connected in series to one another, thus constituting battery block 2. Charging-discharging circuit 3 includes input-output switches connected in series to an output side of battery block 2. The input-output switches are turned on and off when battery block 2 is charged and discharged. The input-output switches are implemented by semiconductor switches, such as FETs or transistors. Upon detecting over-charging or over-discharging, the input-output switches are turned off. Fuse 4 is connected in series to battery block 2 and blows upon occurrence of abnormal conditions in secondary battery cells 1, thereby cutting off the current from battery block 2. Current-detecting resistor 5 is configured to detect a charging and discharging current flowing through charging-discharging path CL.

A/D converter-failure detection device 100 includes first IC 10, second IC 20, and reference-signal generator 30.

First IC 10 is an AFE configure to measure the temperature of secondary battery cells 1 or electric current value of secondary battery cells 1. Second IC 20 is an MCU configured to control power supply device 1000. The AFE of first IC 10 measures a battery voltage of each of secondary battery cells 1, the charging and discharging currents of the cells, the temperature of the cells, the temperature of electronic components such as switching elements constituting charging-discharging circuit 3. First IC 10 detects, by using current-detecting resistor 5, the charging and discharging currents that flow through charging-discharging path CL, and transmits the detected value to second IC 20. First IC 10 further detects the voltage of each of secondary battery cells 1, and transmits the detected value to second IC 20. First IC 10 further detects the temperature of secondary battery cells 1 in accordance with a signal from temperature sensor 6 thermally coupled to secondary battery cells 1. Each of the analog signals detected by first IC 10 is A/D-converted by first A/D converter 11 into a digital signal, and then processed by the MPU, i.e., second IC 20. Second IC 20 detects the voltage of each of secondary battery cells 1 constituting battery block 2, and controls the turning on and off of input-output switches 2.

Power supply device 1000 further includes second protection circuit 7 monitoring over-charging. Upon detecting over-charging by second protection circuit 7, second IC 20 halts the charging.

### Failure Detection Method of A/D Converter-Failure Detection Device

A failure detection method of A/D converter-failure detection device 100 described above will be described below. First IC 10 detects a first analog value of a reference signal via first reference terminal 15, causes first A/D converter 11 to convert the detected first analog value into a first digital signal at a first resolution, and then, transmits the first digital signal from first communication terminal 16 to second communication terminal 26. Second IC 20 detects a second analog value of the reference signal via second reference terminal 25, and then causes second A/D converter 21 to convert the detected second analog value into a second digital signal at a second resolution.

Then, second IC 20 receives, at second communication terminal 26, the first digital signal transmitted from first IC 10. Then, second IC 20 compares the first digital signal with the second digital signal to obtain a difference between the first and second signals. Then, when the difference exceeds a predetermined reference value, second IC 20 determines that a failure has occurred. That is, second IC 20 compares the first digital signal with the second digital signal. Then, when the difference between the first digital signal and the second digital signal exceeds the predetermined reference value, second IC 20 determines that a failure has occurred in at least one of A/D converters 11 and 21. The failure detection of A/D converters may be thus performed by software. In the case where the first resolution of first A/D converter 11 is different from the second resolution of second A/D converter 21, the signals at the resolutions of the converters are normalized before the comparison.

In the example described above, the failure determination is performed by comparing the digital signal that has been A/D-converted from a signal by the A/D converter of first IC 10 with the digital signal that has been A/D-converted from the signal by the A/D converter of second IC 20. However, the present disclosure is not limited to this configuration. Failure determination may be performed by comparing, with one another, three or more digital signals that have been obtained by A/D-converting the same analog signal by respective three or more ICs. This method allows accurate failure determination. In particular, although two ICs determine failure occurrence when the difference between the signals exceeds a threshold value, it cannot be determined which IC is out of order in the A/D conversion function. In contrast, three or more ICs for comparison determine that a failure has occurred in the IC exhibiting a larger difference than the other ICs, resulting in an advantage of identification of the faulty A/D conversion function.

In the example described above, power supply device 1000 supplies electric power to an electrical apparatus, i.e., a powering target, by being mounted in the electrical apparatus. Further, when the remaining capacity of the power supply device becomes low or when the power supply device has deteriorated with age, the power supply device may be replaced with a new one to continuously use the electrical apparatus. However, the present disclosure is not limited to the power supply device of such a replaceable type that mainly accommodates secondary battery cells, but may also be applied to the configuration of another mode in which secondary battery cells are accommodated inside the housing of an electrical apparatus. In the present disclosure, the power supply device may have any configuration in which secondary battery cells are accommodated inside a housing such as a case. Therefore, the power supply device may also include a device having a configuration in which secondary battery cells for powering an electrical apparatus are accommodated inside the housing of the electrical apparatus itself. That is, the present disclosure is not limited to the power supply device of a replaceable type, but is also applicable to the electrical apparatus having built-in secondary battery cells.

### INDUSTRIAL APPLICABILITY

An A/D converter-failure detection device, and a power supply device including the A/D converter-failure detection device, and the A/D converter-failure detection method in accordance with the present disclosure are preferably applicable to electric power sources for powering electrical apparatuses that include: power-assisted bicycles, autonomously travelling robots for home-delivery service, electric carts for home-delivery service and golf course service, electric scooters, construction machines, and vehicles e.g. hybrid vehicles and electric vehicles. In addition, they are also preferably used optionally in applications that include power supply devices for portable electrical apparatuses such as radio devices, electric cleaners, and electric tools; and stationary power storages for backup power supplies of servers and for power supply devices of households, business places, and factories.

### FERENCE MARKS IN THE DRAWINGS

- 1000: power supply device
- 100: A/D converter-failure detection device
- 1: secondary battery cell
- 2: battery block
- 3: charging-discharging circuit
- 4: fuse
- 5: current-detecting resistor
- 6: temperature sensor
- 7: second protection circuit
- 10: first IC
- 11: first A/D converter
- 12: first controller
- 13: first communication unit
- 14: analog input terminal
- 15: first reference terminal
- 16: first communication terminal
- 17: communication line
- 20: second IC
- 21: second A/D converter
- 22: second controller
- 23: second communication unit
- 25: second reference terminal
- 26: second communication terminal
- 30: reference-signal generator
- 31: power supply circuit
- 32: voltage converter circuit
- VP: power supply voltage
- VDD1: power voltage of first IC
- VDD2: power voltage of second IC
- CL: charging-discharging path

## Claims

1. An A/D converter-failure detection device comprising:
a first IC including
a first reference terminal configured to acquire a first analog value of a predetermined reference signal,
a first A/D converter configured to convert the first analog value acquired at the first reference terminal into a first digital signal at a first resolution, and
a first communication terminal configured to communicate with a part other than the first IC; and
a second IC including
a second reference terminal configured to acquire a second analog value of the predetermined reference signal,
a second A/D converter configured to convert the second analog value acquired at the second reference terminal into a second digital signal at a second resolution, and
a second communication terminal connected to the first communication terminal, the second communication terminal and configured to communicate with the first communication terminal, wherein
the first IC is configured to transmit the first digital signal from the first communication terminal to the second communication terminal, the first digital signal being obtained by A/D-converting the first analog value of the predetermined reference signal at the first resolution by the first A/D converter, the first analog value being acquired at the first reference terminal,
the second IC is configured to:
compare the second digital signal with the first digital signal to obtain a difference between the second digital signal and the first digital signal, the second digital signal being obtained by A/D-converting the second analog value of the predetermined reference signal at the second resolution by the second A/D converter, the second analog value being acquired at the second reference terminal, the first digital signal being received at the second communication terminal; and
determine a failure when the difference exceeds a predetermined reference value.

2. The A/D converter-failure detection device according to claim 1, wherein
the first resolution is different from the second resolution, and
the second IC is configured to normalize the first digital signal and the second digital signal in accordance with the first resolution and the second resolution so as to compare the second digital signal with the first digital signal.

3. The A/D converter-failure detection device according to claim 2, wherein the second IC is configured to normalize one of the first digital signal and the second digital signal which is A/D-converted at a higher one of the first resolution and the second resolution to match another of the first digital signal and the second digital signal which is A/D-converted at a lower one of the first resolution and the second resolution.

4. The A/D converter-failure detection device according to claim 3, wherein the first resolution is higher than the second resolution.

5. The A/D converter-failure detection device according to claim 1, further comprising a reference-signal generator configured to generate the predetermined reference signal.

6. The A/D converter-failure detection device according to claim 5, wherein the predetermined reference signal is a predetermined reference voltage.

7. The A/D converter-failure detection device according to claim 6, wherein the reference-signal generator includes a voltage converter circuit configured to convert a power voltage configured to power the first IC or the second IC into the predetermined reference voltage lower than the power voltage.

8. The A/D converter-failure detection device according to claim 1, wherein
the first IC further includes an analog input terminal configured to receive an external analog signal, and
the first IC is configured to:
convert the external analog signal received at the analog input terminal into a digital value by the first A/D converter; and
transmit the digital value from the first communication terminal to the second communication terminal.

9. A power supply device comprising:
the A/D converter-failure detection device according to any one of claims 1 to 8;
one or more secondary battery cells; and
a charging-discharging circuit configured to charge and discharge the one or more secondary battery cells, wherein
the first IC comprises an analog front end (AFE) configured to measure a temperature of the one or more secondary battery cells or an electrical current of the one or more secondary battery cells, and
the second IC comprises a micro controller (MCU) configured to control the power supply device.

10. A failure detection method of an A/D converter-failure detection device, wherein
the A/D converter-failure detection device includes:
a first IC including a first reference terminal connected to a predetermined reference signal, a first A/D converter converting a first analog value of the predetermined reference signal detected at the first reference terminal into a first digital signal at a first resolution, and a first communication terminal communicating with other part; and
a second IC including a second reference terminal connected to the predetermined reference signal, a second A/D converter converting a second analog value of the predetermined reference signal detected at the second reference terminal into a second digital signal at a second resolution, and a second communication terminal connected to and communicating with the first communication terminal, and
the failure detection method comprises:
allowing the first IC to detect the first analog value of the predetermined reference signal at the first reference terminal, to convert the first analog value into the first digital signal at the first resolution by the first A/D converter, and to transmit the first digital signal from the first communication terminal to the second communication terminal;
allowing the second IC to detect the second analog value of the predetermined reference signal at the second reference terminal, and to convert the second analog value into the second digital signal at the second resolution by the second A/D converter;
allowing the second IC to receive, at the second communication terminal, the first digital signal transmitted from the first IC; and
allowing the second IC to compare the first digital signal with the second digital signal to obtain a difference between the first digital signal and the second digital signal, and to determine an occurrence of a failure when the difference exceeds a predetermined reference value.
